# EUROPÄISCHE PATENTANMELDUNG

(11) **EP 0 746 045 A2**
(43) Veröffentlichungstag der Anmeldung: **04.12.1996**
(21) Anmeldenummer: 96106045.6
(22) Anmeldetag: 18.04.1996
(51) Int. Cl.: H01L 33/00, H01L 31/02

(54) **Anordnung zur Montage eines optoelektronischen Bauelementes auf einem Träger**

(30) Priorität: 27.05.1995 DE 19519549
(71) Anmelder: ROBERT BOSCH GMBH, 70442 Stuttgart (DE)
(72) Erfinder: Hauer, Heiner, Dipl.-Ing., 70734 Fellbach (DE); Kuke, Albrecht, Dr.Dr.-Ing., 71549 Auenwald (DE); Möss, Eberhard, Dipl.-Ing., 71540 Murrhardt (DE); Fritscher, Raimund, Dipl.-Ing. (FH), 71576 Burgstetten (DE); Scholz, Werner, Dipl.-Ing. (FH), 71554 Weissach im Tal (DE)

(57) **Zusammenfassung**

Die Erfindung betrifft eine Anordnung zur Montage eines optoelektronischen Bauelementes auf einem Träger mit einem leitfähigen Verbindungsmaterial, das zwischen dem Träger und dem optoelektronischen Bauelement angeordnet ist und im viskosen oder flüssigen Zustand verarbeitet wird, wobei auf dem Träger eine leitfähige Beschichtung und auf der dem Träger zugewandten Seite des optoelektronischen Bauelementes ein Metallisierungsschicht vorgesehen ist.

Bei der bekannten Episide-down-Montage von Lasern treten Nachteile durch Kurzschlüsse und Lotwulste auf.

Die Befestigung und Positionierung des optoelektronischen Bauelementes wird durch eine Strukturierung des Trägers (1) mit das optoelektronische Bauelement (2) umgebenden Nuten (7, 7') erleichtert. Die Nuten (7, 7') dienen erfindungsgemäß dazu, überschüssiges Lot, das seitlich unter dem Bauelement, beispielsweise einem Laserchip, herausquillt und einen Kurzschluß an den Epitaxieschichten verursachen könnte, aufzunehmen. Durch die Benetzung des Lotes auf der Metallisierung (8) bildet sich ein Meniskus (9, 9') aus, der bis in die Nuten hineinreicht. Die Oberflächenspannung dieses Lot-Meniskus zieht den Laserchip in seine gewünschte Sollposition zwischen den beiden Nuten, wodurch der Laserchip ausgerichtet wird.

## Beschreibung

Die Erfindung betrifft eine Anordnung zur Montage eines optoelektronischen Bauelementes auf einem Träger mit einem Verbindungsmaterial, das zwischen dem Träger und dem optoelektronischen Bauelement angeordnet ist und im viskosen oder flüssigen Zustand verarbeitet wird, wobei auf dem Träger eine vom Verbindungsmaterial benetzbare Beschichtung und auf der dem Träger zugewandten Seite des optoelektronischen Bauelementes eine vom Verbindungsmaterial benetzbare Schicht vorgesehen ist.

### Stand der Technik

Haibleiterlaser werden nach dem Stand der Technik mit ihrer Unterseite ganzflächig auf einem ebenen, gut wärmeleitenden Träger aufgelötet. Der Träger dient einerseits zur elektrischen Kontaktierung und andererseits zur Abfuhr der im Laser erzeugten Verlustwärme und wird daher als Wärmesenke bezeichnet. Es sind abhängig von der Polarität der Laserdiode und den Erfordernissen der elektrischen Beschaltung zwei Montagearten des Lasers gebräuchlich, die mit Episide-up und Episide-down bezeichnet werden. Bei Episide-up-Lasern liegen die Epitaxieschichten mit der aktiven Laserzone auf der oberen Seite des Laserchips. Der Laser wird mit seinem Substrat elektrisch leitend auf die Wärmesenke montiert. Der andere elektrische Anschluß erfolgt durch einen Bonddraht auf der Laseroberseite. Bei der Episide-down-Montage wird der Laser mit der Seite, die die Epitaxieschichten und die aktive Laserzone trägt, auf die Wärmesenke montiert. Vorteilhaft bei dieser Montageart ist, daß der Wärmewiderstand zwischen der aktiven Zone und der Wärmesenke hier geringer ist, da die Wärme nicht durch das Substrat des Laserchips abfließen muß. Die Episide-down-Montage hat aber auch einen Nachteil, da die Montage hier wesentlich schwieriger ist. Da die Epitaxieschichten nur wenige Mikrometer über der Lotschicht auf der Wärmesenke liegen, kann es vorkommen, daß an der Seitenfläche des Laserchips die Lotschicht bis an die Epitaxieschichten reicht und diese kurzschließt, was zu einem Ausfall des Lasers führt. Ein Lotwulst, der die Laserschichten kurzschließt, kann beispielsweise dann entstehen, wenn der Laser bei der Montage entweder seitlich auf dem Lot verschoben wird, um die richtige Position zu erreichen oder wenn der Laser in das flüssige Lot eingedrückt wird.

Es ist Aufgabe der Erfindung, eine Anordnung zur Montage eines optoelektronischen Bauelementes auf einem Träger anzugeben, mit der die Positionierung des optoelektronischen Bauelementes erleichtert wird. Die Aufgabe wird durch eine Anordnung mit den Merkmalen des Patentanspruchs 1 gelöst. Vorteilhafte Weiterbildungen sind in den Unteransprüchen angegeben.

Mit der erfindungsgemäßen Anordnung wird die Befestigung des optoelektronischen Bauelementes erheblich erleichtert. Es wird eine Strukturierung des Trägers, der als Wärmesenke dient, vorgeschlagen, mit der die Selbstausrichtung des optoelektronischen Bauelementes erreicht wird. Außerdem werden Probleme mit der Lotschicht vermieden. Es ist besonders vorteilhaft, wenn der Abstand der Nuten der Breite oder Länge des optoelektronischen Bauelementes entspricht. Jedoch führt eine Anordnung mit einer geringfügigen Abweichung zwischen dem Abstand der Nuten und der Breite des optoelektronischen Bauelementes zum selben Ergebnis. Wenn vermieden werden soll, daß Lot die seitlichen Flächen des optoelektronischen Bauelementes benetzt, ist es besonders vorteilhaft den Abstand der Nuten kleiner als die Breite des Bauelementes zu wählen. Um eine gute wärmeabfuhr zu gewährleisten, darf die Kontaktfläche zwischen Träger und Bauelement jedoch nicht beliebig klein sein.

Ein Ausführungsbeispiel der Erfindung ist in den Zeichnungen dargestellt.

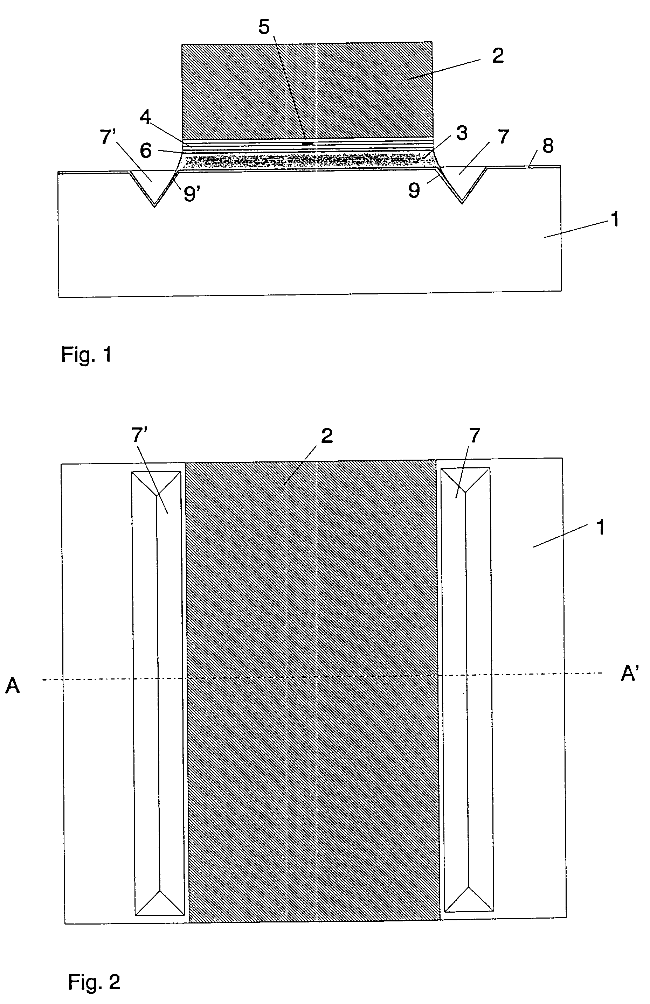

Figur 1 zeigt einen Querschnitt und Figur 2 eine Draufsicht auf eine erfindungsgemäße Anordnung.

Auf einem Träger 1 ist ein Laserchip 2 montiert, wobei zur Fixierung vorzugsweise Lot 3 oder auch ein leitfähiger Kleber verwendet wird. Bei der Episide-down-Montage sind die Epitaxieschichten 4 mit dem aktiven Fenster 5 auf der Unterseite des Laserchips. Die äußerste Epitaxieschicht trägt wie üblich eine Metallisierungsschicht 6, beispielsweise aus Gold (Lotdicke, Metallisierung und Epitaxieschichten sind nicht maßstäblich gezeichnet). Der Träger 1 weist zwei Nuten 7 und 7' auf, die in Längsrichtung des Lasers angeordnet sind. Der Abstand der Nuten voneinander ist etwa so groß wie die Breite des Laserchips. Die Oberfläche des Trägers 1 und der Nuten 7 und 7' ist ebenfalls mit einer Metallisierungsschicht 8 versehen. Die Nuten 7, 7' dienen erfindungsgemäß dazu, überschüssiges Lot, das seitlich unter dem Laserchip herausquillt und einen Kurzschluß an den Epitaxieschichten verursachen könnte, aufzunehmen. Durch die Benetzung des Lotes auf der Metallisierung 8 bildet sich ein Meniskus 9 bzw. 9' aus, der bis in die Nuten hineinreicht. Die Oberflächenspannung dieses Lot-Meniskus zieht den Laserchip in seine gewünschte Soliposition zwischen den beiden Nuten, wodurch der Laserchip ausgerichtet wird.

Der Träger, der auch als Wärmesenke bezeichnet wird, kann vorzugsweise aus Silizium hergestellt sein. Silizium hat eine sehr hohe Wärmeleitfähigkeit und kann durch anisotropes Ätzen mikromechanisch strukturiert werden. Auf diese Weise können die Nuten 7 und 7' mit sehr hoher Präzision hergestellt werden. Werden auf dem Siliziumträger weitere Halterungsnuten, beispielsweise zur Aufnahme von optischen Abbildungselementen durch mikromechanische Strukturierung im gleichen Maskenprozeß hergestellt, so erhält man eine sehr genaue Ausrichtung der Laserposition oder der Position eines anderen optoelektrischen Bauelementes zur Position der optischen Abbildungselemente, was sehr wichtig für die exakte Führung des Lichtes ist.

Die Möglichkeit einer exakten Positionierung durch geätzte Nuten in einem Siliziumträger läßt sich auch für Laser mit Episide-up-Struktur verwenden. Ebenso kann dadurch die laterale Position von anderen optoelektronischen oder elektronischen Bauelementen, wie z.B. Photodioden oder integrierten Schaltkreisen, durch geätzte Nuten sehr genau festgelegt werden. Je nach Anwendungsfall können diese Nuten nicht nur an zwei Seiten sondern auch an allen vier Seiten angeordnet sein. Eine Befestigung muß nicht mit Lot oder einem leitfähigen Verbindungsmaterial durchgeführt werden. Auch ein Kleber kann zum Einsatz kommen, der sich auf den benetzbaren Oberflächen ausbreitet.

## Patentansprüche

1. Anordnung zur Montage eines optoelektronischen Bauelementes auf einem Träger mit einem Verbindungsmaterial (3), das zwischen Träger (1) und optoelektronischem Bauelement (2) angeordnet ist und in viskosem oder flüssigem Zustand verarbeitet wird, wobei auf dem Träger (1) eine vom Verbindungsmaterial benetzbare Beschichtung (8) und auf der dem Träger (1) zugewandten Seite des optoelektronischen Bauelementes (2) eine vom Verbindungsmaterial benetzbare Schicht (6) vorgesehen ist, dadurch gekennzeichnet, daß auf dem Träger (1) Nuten (7, 7') vorgesehen sind, die sich an gegenüberliegenden Seiten des optoelektronischen Bauelementes (2) befinden, deren Wandungen ebenfalls eine vom Verbindungsmaterial benetzbare Beschichtung (8) aufweisen und deren Abstand derart gewählt ist, daß der Abstand der Nuten (7, 7') auf der Oberfläche des Trägers (1) nicht um mehr als die Dicke des Verbindungsmaterials (3) zwischen der Beschichtung (8) und der Schicht (6) größer als die Breite des optoelektronischen Bauelementes (2) ist oder daß der Abstand der Nuten (7, 7') auf der Oberfläche des Trägers (1) kleiner als die Breite des optoelektronischen Bauelementes (2) ist.

2. Anordnung zur Montage eines optoelektronischen Bauelementes nach Anspruch 1, dadurch gekennzeichnet, daß zwischen dem Träger (1) und dem optoelektronischem Bauelement (2) ein leitfähiges Verbindungsmaterial (3), angeordnet ist, das in viskosem oder flüssigem Zustand verarbeitet wird, daß auf dem Träger (1) eine leitfähige Beschichtung (8) und auf der dem Träger (1) zugewandten Seite des optoelektronischen Bauelementes (2) eine weitere leitfähige Schicht (6) vorgesehen ist, daß auf dem Träger (1) Nuten (7, 7') vorgesehen sind, deren Wandungen ebenfalls eine leitfähige Beschichtung (8) aufweisen.

3. Anordnung zur Montage eines optoelektronischen Bauelementes auf einem Träger nach einem der Ansprüche 1 oder 2, dadurch gekennzeichnet, daß der Abstand der Nuten (7, 7') der Breite des Bauelements (2) entspricht.

4. Anordnung zur Montage eines optoelektronischen Bauelementes auf einem Träger nach einem der Ansprüche 1 oder 2, dadurch gekennzeichnet, daß der Abstand der Nuten (7, 7') maximal 10% kleiner als die Breite des Bauelementes ist.

5. Anordnung zur Montage eines optoelektronischen Bauelementes auf einem Träger nach einem der Ansprüche 1 bis 4, dadurch gekennzeichnet, daß sich an der Begrenzung zwischen optoelektronischem Bauelement (2) und Nut (7, 7') in jeder seitlichen Nut ein Meniskus aus dem Verbindungsmaterial (3) ausbildet.

6. Anordnung zur Montage eines optoelektronischen Bauelementes auf einem Träger nach einem der Ansprüche 1 bis 5, dadurch gekennzeichnet, daß sich an jeder Seite des optoelektronischen Bauelementes (2) im Träger (1) eine Nut (7, 7') befindet.

7. Anordnung zur Montage eines optoelektronischen Bauelementes auf einem Träger nach einem der Ansprüche 1 bis 6, dadurch gekennzeichnet, daß die im Träger (1) vorgesehenen Nuten (7, 7') durch anisotropes Ätzen hergestellt sind.

8. Anordnung zur Montage eines optoelektronischen Bauelementes auf einem Träger nach einem der Ansprüche 1 bis 7, dadurch gekennzeichnet, daß als optoelektronisches Bauelement (2) ein Laser vorgesehen ist.
